# EUROPEAN PATENT APPLICATION

(11) **EP 2 079 167 A1**
(43) Date of publication of application: **15.07.2009**
(21) Application number: 08022388.6
(22) Date of filing: 23.12.2008
(51) Int. Cl.: H03K 19/00

(54) **Method and apparatus for controlling leakage in a circuit**

(30) Priority: 10.01.2008 US 972215
(71) Applicant: Broadcom Corporation, Irvine CA 92617 (US)
(72) Inventor: Wang,Janet, San Francisco CA 94109 (US); Chen, Vincent, Newport Coast CA 92657 (US); Manian, Vahid, Coto de Caza CA 92679 (US)
(74) Representative: Jehle, Volker Armin

(57) **Abstract**

A system includes an apparatus for reducing leakage in a circuit. The apparatus includes one or more active devices connected to form a main circuit portion and at least one other active device coupled between the main circuit portion and one from the group including ground and Vdd, the other active device being configured to control leakage in the main circuit portion. A gate length, a gate oxide, and a threshold voltage of the other active device are optimized for low leakage.

## Description

### BACKGROUND OF THE INVENTION

### Field of the Invention

The present invention generally relates to leakage in advanced technology semiconductor device circuits.

### Related Art

Power gating is a circuit technique well known to those of skill in the art. By way of background, power gating is a circuit technique used to control leakage in semiconductor circuit chips. More particularly, in power gating, a sleep (i.e., gating) transistor is added between core circuit elements and a circuit ground. Optionally, a power gating transistor could also be implemented between the circuit elements and the power supply Vdd. Through placement between the core circuit elements and the circuit ground, the gating transistor can be turned on and off to control or eliminate a leakage path between these core elements and ground. Correspondingly, if connected to Vdd, the power gating transistor is used to eliminate leakage between the core circuit elements and the Vdd power supply. In other words, the gating transistor controls power dissipation to and from the core circuit elements.

Although widely used, power gating is not without shortcomings. For example, traditional gating transistors, although reducing leakage, still permit a significant amount of leakage between the core circuit elements and ground. In fact, since transistors are active devices, gating transistors actually add a small, though somewhat tolerable, amount of leakage to the circuit. Despite these shortcomings, however, power gating circuit techniques are rapidly becoming the preferred approach for leakage reduction.

By way of example, achieving leakage reduction via process technology is one alternative approach. But as transistor performance characteristics continue to increase, while their size decreases, reducing leakage through process technology techniques is becoming more difficult. Therefore, companies producing devices in the 90 nanometer (nm), 65 nm, 45 nm, range, and below, are largely using power gating circuit techniques due to difficulties in controlling leakage by using process technology.

What is needed, therefore, is an approach to reducing the deficiencies of power gating as an effective leakage reduction technique.

### BRIEF SUMMARY OF THE INVENTION

Consistent with the principles of the present invention as embodied and broadly described herein, the present invention includes an apparatus for reducing leakage in a circuit. The apparatus includes one or more active devices connected to form a main circuit portion and at least one other active device coupled between the main circuit portion and one from the group including ground and Vdd, the other active device being configured to control leakage in the main circuit portion. A gate length, a gate oxide, and a threshold voltage of the other active device are optimized for low leakage.

Contrary to the trend established in advanced process technologies where transistor performance characteristics are pushed to the limits, the present invention follows a different path for reducing leakage. In the present invention, a lower performance transistor is used as a gating device in a circuit that has higher performance transistors as its core circuit elements.

In an embodiment of the present invention, for example, when core circuit elements include higher performing 40 nm devices or smaller, for example, a 130 nm LP (low power) transistor can be used as a gating device. In conventional circuits using higher performing 40 nm devices, the gating device would typically also be a 40 nm device.

The inventors of the present application, however, have discovered that significant reductions in leakage can be achieved via the higher gate lengths, thicker gate oxide, and an inherently higher threshold voltage (Vt) associated with lower performing devices, such the 130 nm LP device. While all active devices add a small amount of leakage when used as a gating device, this amount of leakage (when following the approach of the present invention) is relatively small in the overall scheme of reducing leakage in the core circuit elements.

Further embodiments, features, and advantages of the present invention, as well as the structure and operation of the various embodiments of the present invention, are described in detail below with reference to the accompanying drawings.

### BRIEF DESCRIPTION OF THE DRAWINGS

The accompanying drawings, which are incorporated in and constitute part of the specification, illustrate embodiments of the invention and, together with the general description given above and the detailed description of the embodiment given below, serve to explain the principles of the present invention. In the drawings:

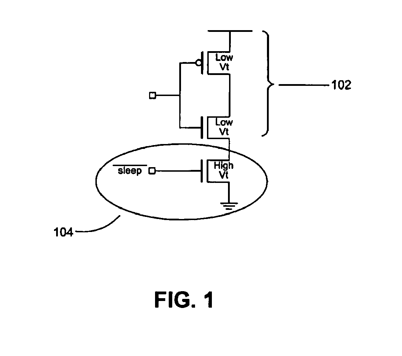

FIG. 1 is a circuit constructed and arranged in accordance with an embodiment of the present invention.

### DETAILED DESCRIPTION OF THE INVENTION

The following detailed description of the present invention refers to the accompanying drawings that illustrate exemplary embodiments consistent with this invention. Other embodiments are possible, and modifications may be made to the embodiments within the spirit and scope of the invention. Therefore, the detailed description is not meant to limit the invention. Rather, the scope of the invention is defined by the appended claims.

It would be apparent to one of skill in the art that the present invention, as described below, may be implemented in many different embodiments of software, hardware, firmware, and/or the entities illustrated in the figures. Any actual software code with the specialized control of hardware to implement the present invention is not limiting of the present invention. Thus, the operational behavior of the present invention will be described with the understanding that modifications and variations of the embodiments are possible, given the level of detail presented herein.

FIG. 1 is an illustration of an exemplary circuit 100 constructed in accordance with an embodiment of the present invention. The exemplary circuit 100 includes core circuit elements 102, which form an inverter. An inverter is shown as merely an example of a circuit in which the present invention can be implemented. The present invention, however, is not limited to the implementation of the circuit 100.

In the circuit 100, an active device (transistor) 104 is connected between the core circuit elements 102 and ground, and is configured as a gating device. More specifically, the transistor 104 acts as a switch to control leakage in the core circuit elements 102. The transistor 104 is configured to switch on (i.e., connect to ground) the circuit elements 102 when they are needed by connecting them to a power supply. The circuit elements are switched off (i.e., disconnected from ground) when then they are not needed.

As would be appreciated by one of skill in the art, any transistor that would be used as a switch, such as the transistor 104, would have to be sufficiently fast to switch the core circuit elements 102 to the power supply. The challenge, however, is to prevent this fast switching transistor from adding to the overall leakage problem associated with the core elements 102 of the circuit 100.

The conventional circuit based leakage reduction technique implements the gating transistor as a higher Vt replica of the core circuit elements. For example, if the core circuit elements 102 are 65 nm or 45 nm devices, then those devices would likely have a relatively low Vt in order to operate at optimum speed. Correspondingly, the gating device would likely also be a 65 nm or 45 nm device, but with a slightly higher Vt. Even with a slightly higher Vt, a 65 nm or 45 nm device is still considered to be a high performance device and as such, would still be a relatively leaky transistor.

In the present invention, however, the 65 nm or 45 nm transistor gating device of the conventional approach is replaced with a less leaky lower performing device.

In the present invention, by way of example, the 65 nm or 45 nm gating transistor could be replaced by a 130 nm LP transistor. Devices such as the 130 nm LP devices are well known to those of skill in the art and are standard devices used in the semiconductor industry. A 130 nm LP transistor, or similar device, would have a longer gate (i.e., channel) length (L) on the order of 130 nm, instead of instead of 45 or 65 nm. The longer gate length will aid in leakage reduction. A 130 nm LP transistor will also have a thicker gate oxide which also helps to reduce leakage. For example, a 65 or 45 nm transistor might have a corresponding gate length of around 14 angstroms. A 130 nm LP, or similar device, on the other hand, might have a gate length of around 20 angstroms. Finally, the 130 nm LP (or similar) device would have a much higher Vt than the 65 nm or 45 nm transistor.

Two of the major leakage contributors in advanced technology devices are the leakage from the short channel lengths, coupled with gate leakage from the thinner gates. Devices such as the industry standard 130 nm LP device, noted above, have a thicker gate oxide, longer channel lengths, and are subsequently much better at reducing leakage than higher performing transistors. By replacing the gating device by something that resembles the 130 nm LP device, the required operating performance can still be achieved, but with a much lower leakage contribution than from a traditional higher performance gating device.

### CONCLUSION

The present invention has been described above with the aid of functional building blocks illustrating the performance of specified functions and relationships thereof. The boundaries of these functional building blocks have been arbitrarily defined herein for the convenience of the description. Alternate boundaries can be defined so long as the specified functions and relationships thereof are appropriately performed.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. An apparatus for reducing leakage in a circuit, comprising:
one or more active devices connected to form a main circuit portion; and
at least one other active device coupled between the main circuit portion and one from the group including ground and Vdd, the other active device being configured to control leakage in the main circuit portion;
wherein a gate length, a gate oxide, and a threshold voltage of the other active device are optimized for low leakage.

2. The apparatus of claim 1, wherein the gate length, the gate oxide, and the threshold voltage of the other active device are greater than a gate length, a gate oxide, and a threshold voltage of the one or more active devices.

3. The apparatus of claim 2, wherein the active devices are transistors.

4. The apparatus of claim 1, wherein the active devices are 130 nm low power (LP) devices.

5. An apparatus comprising:
a first circuit portion including a first active device; and
a second circuit portion coupled to the first circuit portion, the second circuit portion including a second active device coupled between the first circuit portion and one of ground and Vdd;
wherein a gate length, a gate oxide, and a threshold voltage of the second active device are optimized for low leakage.

6. The apparatus of claim 5, wherein the gate length, the gate oxide, and the threshold voltage of the second active device are greater than a gate length, a gate oxide, and a threshold voltage of first the active device.

7. The apparatus of claim 6, wherein the active devices are transistors.
